# EUROPÄISCHE PATENTSCHRIFT

(11) **EP 3 918 679 B1**
(45) Veröffentlichungstag und Bekanntmachung des Hinweises auf die Patenterteilung: **23.09.2026**
(21) Anmeldenummer: 20700872.3
(22) Anmeldetag: 09.01.2020
(51) Int. Cl.: H01S 5/40, H01S 5/223, H01S 5/042, H01S 5/10, H01S 5/22, H01S 5/20, H01S 5/16, H01S 5/30, H01S 5/026

(54) **VORRICHTUNG ZUR ERZEUGUNG VON LASERSTRAHLUNG**
DEVICE FOR GENERATING A LASER BEAM
DISPOSITIF DE PRODUCTION D'UN RAYONNEMENT LASER

(30) Priorität: 31.01.2019 DE 102019102499
(43) Veröffentlichungstag der Anmeldung: 08.12.2021
(73) Patentinhaber: Ferdinand-Braun-Institut gGmbH, Leibniz-Institut für Höchstfrequenztechnik, 12489 Berlin (DE)
(72) Erfinder: ERBERT, Götz, 02708 Löbau (DE); WENZEL, Hans, 12355 Berlin (DE); KNIGGE, Steffen, 15711 Königs Wusterhausen (DE); MARTIN, Christian Dominik, 10825 Berlin (DE); MAASSDORF, Andre, 10437 Berlin (DE); DELLA CASA, Pietro, 12489 Berlin (DE); KNIGGE, Andrea, 15711 Königs Wusterhausen (DE); CRUMP, Paul, 10245 Berlin (DE)
(74) Vertreter: Gulde & Partner
(86) Internationale Anmeldenummer: PCT/EP2020/050462
(87) Internationale Veröffentlichungsnummer: WO 2020/156775

(56) Entgegenhaltungen:
- DE-A1- 102008 022 941
- JP-A- S63 222 488
- US-A- 5 297 158
- US-A- 5 359 619
- US-A- 5 974 069
- US-A1- 2001 017 870
- US-A1- 2001 043 631
- US-A1- 2003 132 454
- US-A1- 2005 121 682
- US-A1- 2011 128 985
- US-A1- 2011 128 986

## Beschreibung

Die vorliegende Erfindung betrifft eine Vorrichtung zur Erzeugung von Laserstrahlung.

### Stand der Technik

Generell besitzen kantenemittierende Laserdioden (Diodenlaser) eine aktive Schicht, welche in Halbleiterschichten eingebettet ist, die sich durch ihre Bandlücken, Brechzahlen und Dotierung voneinander unterscheiden. Die Schichten unterhalb und oberhalb der aktiven Schicht unterscheiden sich dabei insbesondere durch den Leitungstyp (n oder p). Neben der Gewährleistung des Transports von Elektronen und Löchern zur aktiven Schicht, wo sie stimuliert rekombinieren und Laserstrahlung erzeugen, dienen diese Schichten der vertikalen Führung des Laserlichtes. Die der aktiven Schicht benachbarten Schichten werden als Wellenleiterschichten bezeichnet, die diesen Wellenleiterschichten benachbarten Schichten als Mantelschichten. Typischerweise ist die Brechzahl der aktiven Schicht größer als die der Wellenleiterschichten und die Brechzahl der Wellenleiterschichten größer als die der Mantelschichten [E. Kapon (Ed.): "Semiconductor Lasers I: Fundamentals", Academic Press 1998]. Jedoch sind auch andere Konfigurationen möglich (z. B. Vertical ARROW (H. Wenzel u. a.: "High-power diode lasers with small vertical beam divergence emitting at 808 nm", Electronics Letters vol. 37 (2001)], Photonic Band Crystal [M.V. Maximum u. a.: "Longitudinal photonic bandgap crystal laser diodes with ultra-narrow vertical beam divergence", Proc. SPIE vol. 6115 (2006)]).

Die epitaktisch gewachsene Halbleiter-Schichtstruktur eines kantenemittierenden Diodenlasers wird durch einen großflächigen metallischen n-Kontakt und einen definierten metallischen p-Kontakt elektrisch kontaktiert. Zwischen beiden Kontakten wird eine elektrische Spannung derart angelegt, dass ein elektrischer Strom zwischen beiden Kontakten fließt, durch den Löcher und Elektronen in die aktive Schicht injiziert werden. Die Breite des n-Kontakts ist dabei häufig identisch mit der Breite des Laserchips. Die Abmessungen des p-Kontakts werden entsprechend der gewünschten Emissionsapertur gewählt. Aufgrund der lateralen Verbreiterung des Strompfades zwischen p-Kontakt und aktiver Schicht ist die elektrisch gepumpte Fläche stets breiter als der p-Kontakt. Die sogenannte Strompfadverbreiterung tritt vor allem in der hochdotierten Kontaktschicht, aber auch in den darunterliegenden p-dotierten Schichten auf.

DE 10 2008 014 093 A1 offenbart eine Laserdiode, die geeignet ist Laserstrahlung mit verringerter Strahldivergenz zu erzeugen.

Nachteilig ist jedoch, dass durch den schmalen p-Kontakt der elektrische Widerstand hoch ist und die Wärmeleitfähigkeit gering, außerdem können durch die relativ schmale p-Kontaktschicht Kristalldefekte durch von außen ausgeübte mechanische Verspannungen entstehen.

US 2011/0128985 A1 zeigt einen Halbleiterlaser mit einer n-dotierten Stromsperrschicht, welche auf der Oberfläche einer p-dotierten Mantelschicht unter Ausschluss einer oberen Fläche einer streifenförmige Rippenstruktur des Halbleiterlasers angeordnet ist. Die Stromsperrschicht bildet einen p-n-Übergang gegenüber der p-dotierten Mantelschicht aus und wird durch entsprechende Anpassung der Dotierung beim Schichtwachstum erzeugt. US 2011/128986 A1 offenbart eine Halbleiterlaservorrichtung mit Stromverengungsstruktur, die eine Elektroden-zu-Elektroden-Resonanz von Laserlicht unterdrücken kann, wodurch die elektrische Umwandlungseffizienz erhöht werden soll. JPS 63-222488 A betrifft ein Herstellungsverfahren für einen Diodenlaser mit einer Strombarriere.

### Offenbarung der Erfindung

Es ist daher Aufgabe der vorliegenden Erfindung, einen geringen elektrischen Widerstand des p-Kontakts trotz geringer Strahldivergenz zu realisieren.

Diese Aufgaben werden erfindungsgemäß durch die Merkmale des Patentanspruchs 1 (Vorrichtung), sowie des Patentanspruchs 10 (Verfahren) gelöst. Zweckmäßige Ausgestaltungen der Erfindung sind in den Unteransprüchen enthalten.

Ein erfindungsgemäßer Diodenlaser umfasst erste n-leitend ausgebildete Funktionsschichten; einen metallischen n-Kontakt; eine aktive Schicht, die zur Erzeugung elektromagnetischer Strahlung geeignet ist und die auf den ersten Funktionsschichten angeordnet ist; zweite p-leitend ausgebildete Funktionsschichten, die auf der aktiven Schicht angeordnet sind, wobei die zweiten Funktionsschichten erste p-leitende Schichten und zweite p-leitende Schichten umfassen, wobei die ersten p-leitenden Schichten eine p-Wellenleiterschicht und eine p-Mantelschicht umfassen und die zweiten p-leitenden Schichten eine p-Kontaktschicht umfassen; einen metallischen p-Kontakt; eine Strombarriere, die zwischen den ersten p-leitenden Schichten und den zweiten p-leitenden Schichten angeordnet ist; und mindestens eine Facette zur Auskopplung elektromagnetischer Strahlung entlang einer ersten Achse, wobei die ersten Funktionsschichten, die aktive Schicht und die zweiten Funktionsschichten entlang einer zweiten Achse gestapelt sind; wobei sich die Strombarriere entlang einer dritten Achse erstreckt; wobei die Strombarriere mindestens eine Öffnung aufweist; wobei eine erste Breite der Öffnung entlang der dritten Achse kleiner als eine zweite Breite des metallischen p-Kontaktes entlang der dritten Achse ist und eine Projektion der ersten Breite auf den metallischen p-Kontakt innerhalb der zweiten Breite liegt; wobei eine Dicke der Strombarriere größer als 0.1 µm ist; wobei die Strombarriere durch das Einbringen von Fremdatomen in die ersten p-leitenden Schichten mittels Implantation oder Diffusion ausgebildet ist; wobei ein spezifischer elektrischer Widerstand der Strombarriere mehr als das Zweifache eines spezifischen elektrischen Widerstands der Schichtstruktur ist; und wobei die Dicke der ersten p-leitenden Schichten kleiner als 2 µm und die Dicke der zweiten p-leitenden Schichten größer als 0.5 µm ist.

Die Idee der vorliegenden Erfindung ist es, eine Strombarriere derart in einen Diodenlaser einzubringen, dass die Kontaktflächengröße des metallischen p-Kontakts und die Dicke der unter dem metallischen p-Kontakt liegenden zweiten p-leitenden Schichten erhöht werden können. Dies hat den Vorteil, dass durch die große p-Kontaktfläche der elektrische Widerstand erheblich gesenkt werden kann, ohne dabei die Strahleigenschaften negativ zu beeinflussen und dickere zweite p-leitende Schichten erlauben es, mechanische Verspannungen leichter abzubauen, was sich positiv auf die Lebensdauer und Strahlqualität des Lasers auswirkt.

Vorzugsweise ist die Strombarriere nur in Teilbereichen der ersten p-leitenden Schichten eingebracht.

Die ersten p-leitenden Schichten umfassen eine p-Wellenleiterschicht und eine p-Mantelschicht, noch bevorzugter bestehen die ersten p-leitenden Schichten aus genau einer p-Wellenleiterschicht und einer p-Mantelschicht.

Die zweiten p-leitenden Schichten umfassen eine p-Kontaktschicht, noch bevorzugter bestehen die zweiten p-leitenden Schichten aus genau einer p-Kontaktschicht.

Vorzugsweise ist eine Dicke der ersten p-leitenden Schichten kleiner als eine Dicke der zweiten p-leitenden Schichten. Dies ist vorteilhaft, weil dadurch mechanische Verspannungen der Halbleiterschichten abgebaut werden können.

In einer bevorzugten Ausführungsvariante überlappt eine Projektion der Öffnung der Strombarriere entlang der zweiten Achse mit dem metallischen p-Kontakt vollständig, d. h. eine Projektion der ersten Breite entlang der zweiten Achse auf den metallischen p-Kontakt liegt innerhalb der zweiten Breite. Dies hat den Vorteil, dass eine Stromaufweitung verringert und dadurch der Laser effizienter wird.

Gemäß einer weiteren Ausführungsvariante der Erfindung weist die Strombarriere eine Vielzahl von Öffnungen auf, wobei eine Projektion der Öffnungen entlang der zweiten Achse mit dem metallischen p-Kontakt vollständig überlappt. Dies ist vorteilhaft, weil durch die Modulation der Stromdichte und somit der injizierten Ladungsträger in der aktiven Schicht eine Formung des optischen Laserstrahlfeldes und somit eine Verbesserung der Strahlqualität erreicht werden kann.

Vorzugsweise sind alle Öffnungen der Strombarriere gleich breit. Dadurch werden Ungleichheiten der Stromdichte in der aktiven Schicht verhindert und daraus ergeben sich zusätzlich Vorteile für die Strahlqualität.

Weiter bevorzugt ist eine gleichmäßige Verteilung der Öffnungen der Strombarriere entlang der lateralen (dritten) Achse. Hiermit wird eine möglichst vollständige Nutzung der aktiven Zone gewährleistet.

In weiteren erfindungsgemäßen Ausführungsvarianten sind vorzugsweise mindestens zwei aktive Schichten vorgesehen, die entlang der zweiten Achse von einander beabstandet ausgebildet sind, und wobei mindestens zwei Strombarrieren vorgesehen sind (also für mindestens zwei aktive Schichten mindestens zwei entlang der zweiten Achse von einander beabstandete Strombarrieren). Hierdurch ist es möglich, einen Diodenlaser für zwei Frequenzen oder mit der doppelten Ausgangsleistung bei gleichem elektrischen Strom mit den Vorteilen der Strombarrieren zu kombinieren. Hierbei werden zwei Emitter gestapelt.

In einer weiteren erfindungsgemäßen Ausführungsvariante sind vorzugsweise mindestens zwei aktive Schichten vorgesehen, die entlang der zweiten Achse von einander beabstandet ausgebildet sind, wobei nur eine Strombarriere vorgesehen ist. Vorteil dieser Ausführungsvariante ist die einfachere Herstellung, da nur eine Strombarriere ausgebildet werden muss.

Gemäß einer weiteren erfindungsgemäßen Ausführungsvariante sind mindestens zwei Strombarrieren vorgesehen, die entlang der ersten Achse von einander beabstandet sind. Hierdurch wird weiter die aktive Zone möglichst vollständig genutzt und die Strahleigenschaften des Lasers verbessert.

In einer erfindungsgemäßen Ausführungsvariante variiert die Breite der Öffnung der Strombarriere entlang der ersten Achse. Hierbei können die Laserstrahleigenschaften über die erste Achse variiert werden.

Gemäß einer weiteren Ausführungsvariante werden Strombarrieren entlang der ersten Achse im Bereich der Facetten vorgesehen.

Vorzugsweise ist die Differenz zwischen der zweiten Breite des metallischen p-Kontaktes und der ersten Breite der Öffnung der Strombarriere größer als 1 µm, noch bevorzugter größer als 5 µm, noch bevorzugter größer als 20 µm und noch bevorzugter größer als 50 µm. Bei größer werdender Differenz zwischen der zweiten Breite des metallischen p-Kontaktes und der ersten Breite der Öffnung der Strombarriere wird durch den breiterer metallischen p-Kontakt ein geringerer elektrischer Widerstand erreicht und die Wärmeabfuhr wird effizienter, wobei gleichzeitig eine Stromaufweitung verhindert wird.

Die erste Breite der Öffnung der Strombarriere ist vorzugsweise größer als 0.5 µm, bevorzugter größer als 2 µm, bevorzugter größer als 5 µm, bevorzugter größer als 10 µm, bevorzugter größer als 30 µm, bevorzugter größer als 50 µm, bevorzugter größer als 100 µm, bevorzugter größer als 200 µm und noch bevorzugter größer als 400 µm. Durch eine größere Öffnung der Strombarriere wird der Strom effizienter durch die Barriere geleitet, ohne dabei aber eine Stromaufweitung in Kauf zu nehmen.

Vorzugsweise ist die Dicke der Strombarriere größer als 0.10 µm, bevorzugter größer als 0.15 µm, noch bevorzugter größer als 0.20 µm, noch bevorzugter größer als 0.25 µm, noch bevorzugter größer als 0.30 µm, noch bevorzugter größer als 0.40 µm, noch bevorzugter größer als 0.50 µm und noch bevorzugter größer als 1.00 µm. Durch eine dickere Strombarriere wird die elektrische Leitfähigkeit beständiger.

Der Abstand der Strombarriere von der aktiven Schicht ist vorzugsweise kleiner als 1 µm, bevorzugter kleiner als 0.5 µm, bevorzugter kleiner als 0.2 µm, bevorzugter kleiner als 0.1 µm und noch bevorzugter kleiner als 0.01 µm. Durch einen kleineren Abstand der Strombarriere von der aktiven Schicht kann die Stromaufweitung besser verhindert werden.

Die Dicke der ersten p-leitenden Schichten ist vorzugsweise kleiner als 5 µm, bevorzugter kleiner 2 µm, bevorzugter kleiner 1 µm, bevorzugter kleiner 0.5 µm, bevorzugter kleiner als 0.2 µm und noch bevorzugter kleiner als 0.1 µm. Durch kleinere Schichtdicken der ersten p-leitenden Schichten kann das Einbringen der Strombarriere erleichtert werden.

Die Dicke der zweiten p-leitenden Schichten ist vorzugsweise größer als 0.05 µm, bevorzugter größer als 0.1 µm, bevorzugter größer als 0.5 µm, bevorzugter größer als 1 µm und noch bevorzugter größer als 5 µm. Durch größere Schichtdicken der zweiten p-leitenden Schichten, können mechanische Spannungen, die zu Kristalldefekten führen, besser abgebaut werden.

Vorzugsweise ist ein Quotient der Dicke der zweiten p-leitenden Schicht zur Dicke der ersten p-leitenden Schicht größer als 0.1, bevorzugter größer als 0.2, bevorzugter größer als 1, bevorzugter größer als 2 und noch bevorzugter größer als 10. Hieraus ergibt sich der Vorteil, dass die Stromaufweitung nach Durchqueren des Stroms der Strombarriere gering gehalten wird.

Vorzugsweise ist der Diodenlaser als kantenemittierender Diodenlaser ausgebildet. Vorzugsweise ist der Diodenlaser als optischer Verstärker ausgebildet. Damit ergibt sich der Vorteil, dass die Laserdiode möglichst einfach aufgebaut werden kann.

Vorzugsweise ist ein Trägersubstrat (beispielsweise GaAs, InP, GaSb oder GaN) vorgesehen, auf dem die genannte Schichtstruktur aufgebaut ist.

Vorzugsweise sind die ersten n-leitend ausgebildeten Funktionsschichten auf der Seite der aktiven Schicht angeordnet, die dem Trägersubstrat zugewandt ist, wohingegen die zweiten p-leitend ausgebildeten Funktionsschichten auf der Seite der aktiven Schicht angeordnet sind, die dem Trägersubstrat abgewandt ist.

Vorzugsweise ist der metallische n-Kontakt auf der Seite des Trägersubstrates angeordnet, welcher den ersten n-leitend ausgebildeten Funktionsschichten abgewandt ist.

Die Strombarriere weist vorzugsweise einen spezifischen elektrischen Widerstand auf, der signifikant größer ist als der spezifische elektrische Widerstand (im Folgenden bezeichnet als σ_{c}, beispielsweise σ_{c} = 5.5x10⁻⁵ Ω -cm²) der verwendeten Schichtstruktur. Bevorzugt beträgt der spezifische elektrische Widerstand der Widerstandselemente mehr als 2 σ_{c} (beispielsweise 1.1x10⁻⁴ Ω -cm²), weiterhin bevorzugt mehr als 10 σ_{c} (beispielsweise 5.5x10⁻⁴ Ω -cm²), weiterhin bevorzugt mehr als 10² σ_{c} (beispielsweise 5.5x10⁻³ Ω -cm²), weiterhin bevorzugt mehr als 10³ σ_{c} (beispielsweise 5.5x10⁻² Ω -cm²), weiterhin bevorzugt mehr als 10⁴ σ_{c} (beispielsweise 5.5x10⁻¹ Ω -cm²), weiterhin bevorzugt mehr als 10⁵ σ_{c} (beispielsweise 5.5 Ω -cm²), weiterhin bevorzugt mehr als 10⁶ σ_{c} (beispielsweise 5.5x10¹ Ω -cm²), weiterhin bevorzugt mehr als 10⁷ σ_{c} (beispielsweise 5.5x10² Ω -cm²), weiterhin bevorzugt mehr als 10⁸ σ_{c} (beispielsweise 5.5x10³ Ω -cm²), und besonders bevorzugt mehr als 10⁹ σ_{c} (beispielsweise 5.5x10⁴ Ω -cm²).

In einer weiteren bevorzugten Ausgestaltung ist ein Verhältnis der spezifischen Widerstände der Strombarriere bezogen auf den spezifischen Widerstand der verwendeten Schichtstruktur größer als 2, weiterhin bevorzugt größer als 10, weiterhin bevorzugt größer als 10², weiterhin bevorzugt größer als 10³, weiterhin bevorzugt größer als 10⁴, weiterhin bevorzugt größer als 10⁵, weiterhin bevorzugt größer als 10⁶, weiterhin bevorzugt größer als 10⁷, weiterhin bevorzugt größer als 10⁸, und besonders bevorzugt größer als 10⁹.

Vorzugsweise bestehen die ersten p-leitende Schichten und die zweiten p-leitenden Schichten aus unterschiedlichen Materialien.

Weiter bevorzugt bestehen die Strombarriere und die ersten p-leitenden Schichten aus dem gleichen Basismaterial, wobei die Strombarriere mit Fremdatomen dotiert ausgebildet ist.

Ein weiterer Aspekt der vorliegenden Erfindung betrifft ein Verfahren zur Herstellung einer Laserdiode.

Das genannte Verfahren zur Herstellung einer Laserdiode umfasst die folgenden Verfahrensschritte: Ausbilden von ersten n-leitend ausgebildeten Funktionsschichten; Ausbilden einer aktiven Schicht, die zur Erzeugung elektromagnetischer Strahlung geeignet ist und die auf den ersten Funktionsschichten angeordnet ist; Ausbilden von ersten p-leitenden Schichten auf der aktiven Schicht; Einbringen von Fremdatomen in die ersten p-leitenden Schichten zur Ausbildung einer Strombarriere, wobei die ersten p-leitenden Schichten eine p-Wellenleiterschicht und eine p-Mantelschicht umfassen, wobei die Dicke der ersten p-leitenden Schichten kleiner als 2 µm ist; nachfolgendes Ausbilden von zweiten p-leitenden Schichten auf den ersten p-leitenden Schichten, wobei die zweiten p-leitenden Schichten eine p-Kontaktschicht umfassen, wobei die Dicke der zweiten p-leitenden Schichten größer als 0.5 µm ist; Ausbilden eines metallischen n-Kontaktes unter den ersten n-leitend ausgebildeten Funktionsschichten und Ausbilden eines metallischen p-Kontaktes auf den zweiten p-leitenden Schichten; wobei das Einbringen der Fremdatome lediglich in Teilbereichen der ersten p-leitenden Schichten erfolgt; wobei eine Breite eines Teilbereichs der ersten p-leitenden Schichten, in den keine Fremdatome eingebracht werden, kleiner als eine Breite des metallischen p-Kontaktes ist und eine Projektion der ersten Breite auf den metallischen p-Kontakt innerhalb der zweiten Breite liegt, wobei eine Dicke der Strombarriere größer als 0.1 µm ausgebildet wird; wobei die Strombarriere durch das Einbringen von Fremdatomen in die ersten p-leitenden Schichten mittels Implantation oder Diffusion ausgebildet wird; und wobei die Strombarriere derart ausgebildet wird, dass ein spezifischer elektrischer Widerstand der Strombarriere mehr als das Zweifache eines spezifischen elektrischen Widerstands der Schichtstruktur ist.

Bei einer bevorzugten Ausführungsvariante werden die Fremdatome mittels einer strukturierten Maske eingebracht, bevorzugter wird die Maske vor dem Einbringen der Fremdatome auf den ersten p-leitenden Schichten ausgebildet und nach dem Einbringen der Fremdatome in die ersten p-leitenden Schichten wieder entfernt. Hierdurch lassen sich leicht Fremdatome durch beispielsweise Implantation oder Diffusion in die ersten p-leitenden Schichten einbringen.

Vorzugsweise werden als Fremdatome Silizium, Sauerstoff, Eisen oder Selen in die ersten p-leitenden Schichten zur Ausbildung der Strombarriere eingebracht. Dies ergibt eine langzeitstabile und beständige Strombarriere.

Vorzugsweise werden die ersten n-leitend ausgebildeten Funktionsschichten, die aktive Schicht, die ersten p-leitenden Schichten und die zweiten p-leitenden Schichten mittels Epitaxieverfahren ausgebildet.

Vorzugsweise wird bei dem Verfahren die Dicke der ersten p-leitenden Schichten kleiner als die Dicke der zweiten p-leitenden Schichten ausgebildet.

Vorzugsweise wird bei dem Verfahren die Dicke der Strombarriere größer als 0.10 µm, bevorzugter größer als 0.15 µm, noch bevorzugter größer als 0.20 µm, noch bevorzugter größer als 0.25 µm, noch bevorzugter größer als 0.30 µm, noch bevorzugter größer als 0.40 µm, noch bevorzugter größer als 0.50 µm ausgebildet und noch bevorzugter größer als 1.00 µm ausgebildet. Durch eine dickere Strombarriere wird die elektrische Leitfähigkeit beständiger.

Ein breiterer metallischer p-Kontakt senkt den elektrischen Widerstand, was zu einem effizienteren Betrieb des Lasers führt. Ferner wird die Wärmeabfuhr bei einer p-unten Montage des Lasers durch eine größere Kontaktfläche verbessert. Dickere zweite p-leitende Schichten vergrößern den Abstand vom metallischen p-Kontakt zur aktiven Schicht und erlauben so größere Toleranzen bei Facettenbeschichtung und der p-unten Montage. Ferner werden mechanische Verspannungen, welche durch die Montage in die Halbleiterschichten eingebracht werden, über dicke zweite p-leitende Schichten besser abgebaut, wodurch in der Nähe der aktiven Schicht weniger Kristalldefekte erzeugt werden, was die Lebensdauer verbessert. Dickere zweite p-leitende Schichten wirken sich auch positiv auf den Polarisierungsgrad und die Form der thermischen Linse und somit auf die Strahlqualität aus.

Die verschiedenen in dieser Anmeldung genannten Ausführungsformen und Aspekte der Erfindung sind, sofern im Einzelfall nicht anders ausgeführt, mit Vorteil miteinander kombinierbar. Insbesondere sind Darstellungen und Beschreibungen zu bevorzugten Ausgestaltungen und Ausführungsformen des Verfahrens stets entsprechend auf Vorrichtung übertragbar und vice versa.

### Kurzbeschreibung der Zeichnungen

Die Erfindung wird nachfolgend in Ausführungsbeispielen anhand der zugehörigen Zeichnung erläutert. Es zeigen:
- Fig. 1: eine erfindungsgemäße Laserdiode in schematischer geschnittener Darstellung,
- Fig. 2: eine weitere erfindungsgemäße Laserdiode in schematischer geschnittener Darstellung,
- Fig. 3A: noch eine weitere erfindungsgemäße Laserdiode in schematischer geschnittener Darstellung,
- Fig. 3B: noch eine weitere erfindungsgemäße Laserdiode in schematischer geschnittener Darstellung,
- Fig. 4: die erfindungsgemäße Laserdiode aus Fig. 1 in schematischer Darstellung in einer Draufsicht,
- Fig. 5: die erfindungsgemäße Laserdiode aus Fig. 2 in schematischer Darstellung in einer Draufsicht,
- Fig. 6: eine Variante der erfindungsgemäßen Laserdiode aus Fig. 1 in schematischer Darstellung in einer Draufsicht
- Fig. 7: eine weitere Variante der erfindungsgemäßen Laserdiode aus Fig. 1 in schematischer Darstellung in einer Draufsicht und
- Fig. 8: noch eine weitere Variante der erfindungsgemäßen Laserdiode aus Fig. 1 in schematischer Darstellung in einer Draufsicht.

### Ausführliche Beschreibung der Zeichnungen

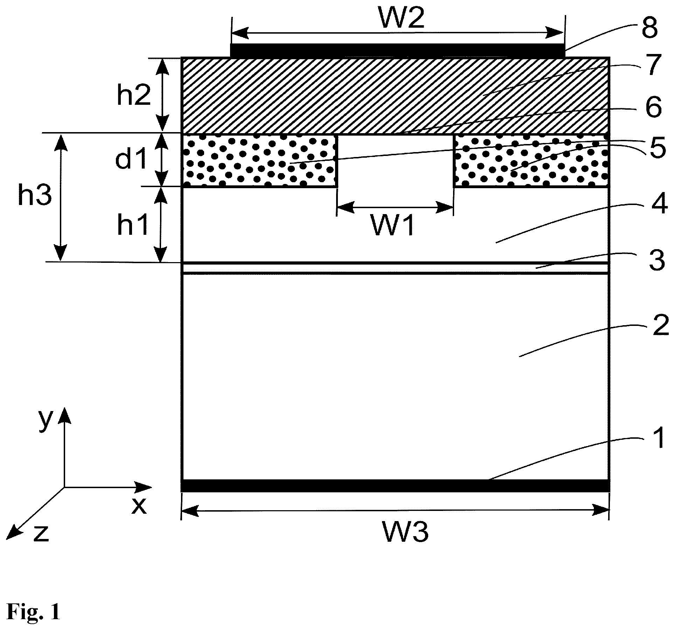

Fig. 1 zeigt eine erste Ausführungsvariante einer erfindungsgemäßen Laserdiode in schematischer geschnittener Darstellung. Die Laserdiode weist einen Schichtaufbau mit einem metallischen n-Kontakt 1, darauf angeordneten ersten n-leitend ausgebildeten Funktionsschichten 2 (einschließlich n-leitendes Trägersubstrat), einer darauf angeordneten aktiven Schicht 3, darauf angeordnete erste p-leitende Schichten 4, einer Strombarriere 5, darauf angeordnete zweite p-leitenden Schichten 7 und einem darauf angeordneten metallischen p-Kontakt 8, wobei zwischen den ersten p-leitenden Schichten 4 und den zweiten p-leitenden Schichten 7 eine Grenzfläche 6 ausgebildet ist. In der Ausführungsvariante in Fig. 1 ist die Strombarriere 5 als ein mit Fremdatomen implantierter Teil der ersten p-leitenden Schichten 4 ausgebildet, wobei der nicht implantierten Teil der ersten p-leitenden Schichten 4 mit einer ersten Dicke h1, die Strombarriere 5 mit einer Dicke d1 und die zweiten p-leitenden Schichten 7 mit einer zweite Dicke h2 ausgebildet sind. Die Strombarriere 5 ist mit einer Öffnung mit der ersten Breite W1 ausgebildet und der metallische p-Kontakt ist mit einer zweiten Breite W2 ausgebildet. Die Breite des metallischen n-Kontaktes ist ausgebildet der dritten Breite W3 des Laserdiodenchips zu entsprechen. Bei dieser Ausführungsvariante wird die Strombarriere 5 mit ihrer Öffnung genutzt, um den Strompfad einzuschränken. Der Strom fließt vom metallischen p-Kontakt 8 durch die Öffnung der Strombarriere 5 in Richtung der aktiven Schicht 3. Die Strombarriere 5 wirkt der Stromaufweitung entgegen. Damit wird gewährleistet, dass ein breiter p-Kontakt 8 genutzt werden kann. Da der Stromaufweitung entgegengewirkt wird, können auch die zweiten p-leitenden Schichten 7 in ihrer Schichtdicke erweitert werden, ohne negative Effekte auf die Stromaufweitung zu haben.

Im bevorzugten Ausführungsbeispiel zur Erzeugung von Laserstrahlung mit einer Wellenlänge von 920 nm z. B. ist die aktive Schicht 3 bevorzugt ausgebildet aus In_{y}Ga_{1-y}As mit einer Dicke von 7 nm und einem molaren In-Anteil y von 10%. Die ersten n-leitende ausgebildeten Funktionsschichten 2, erste p-leitende Schichten 4, Strombarriere 5 und zweite p-leitende Schichten 7 sind aus AlₓGa₁₋ₓAs hergestellt. Die ersten n-leitendend ausgebildeten Funktionsschichten 2 bestehen bevorzugt aus einer n-Mantelschicht mit einem molaren Al-Anteil x in AlₓGa₁₋ₓAs von 35% und einer Schichtdicke von 1,5 µm, einer n-Wellenleiterschicht mit einer Schichtdicke von 2,5 µm, in der der molare Al-Anteil von 35% an der Grenze zur n-Mantelschicht auf 20% an der unteren Grenze zur aktiven Schicht 3 abfällt. Die ersten p-leitenden Schichten 4 mit einer Schichtdicke h3 bestehen aus einer p-leitenden Wellenleiterschicht mit einer Schichtdicke von 0,25 µm, in der der molare Al-Anteil von 20% an der Grenze zur aktiven Schicht 3 auf 70% ansteigt, und einer daran anschließenden p-Mantelschicht mit einer Schichtdicke von 0,6 µm und einem molaren Al-Anteil von 70%. In den zweiten p-leitenden Schichten 7 mit einer Dicke h2 von 1 µm ist der molare Al-Anteil 0%.

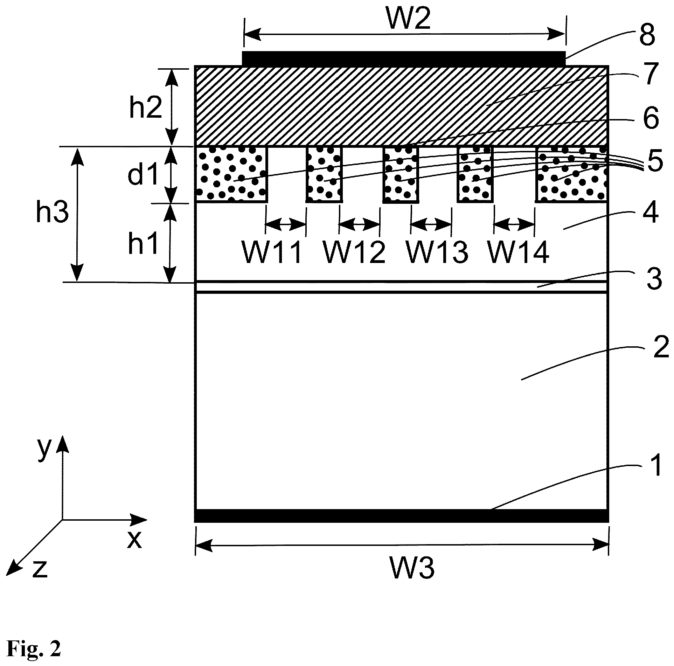

Fig. 2 zeigt eine weitere Ausführungsvariante einer erfindungsgemäßen Laserdiode in schematischer geschnittener Darstellung. Bei dieser Ausführungsvariante ist die Strombarriere 5 beispielhaft mit vier Öffnungen mit Breiten W11, W12, W13 und W14 ausgebildet. Dadurch wird eine Modulation der Stromdichte und somit der injizierten Ladungsträger in der aktiven Schicht entlang der dritten Achse X erreicht, wodurch das optische Laserstrahlfeld geformt wird und eine Verbesserung der Strahlqualität erreicht werden kann. In einer bevorzugten Ausführungsvariante sind die Breiten W11, W12, W13 und W14 der Öffnungen der Stromblende gleich groß, wodurch eine besonders homogene Leistungsverteilung entlang der zweiten Achse Y erreicht wird.

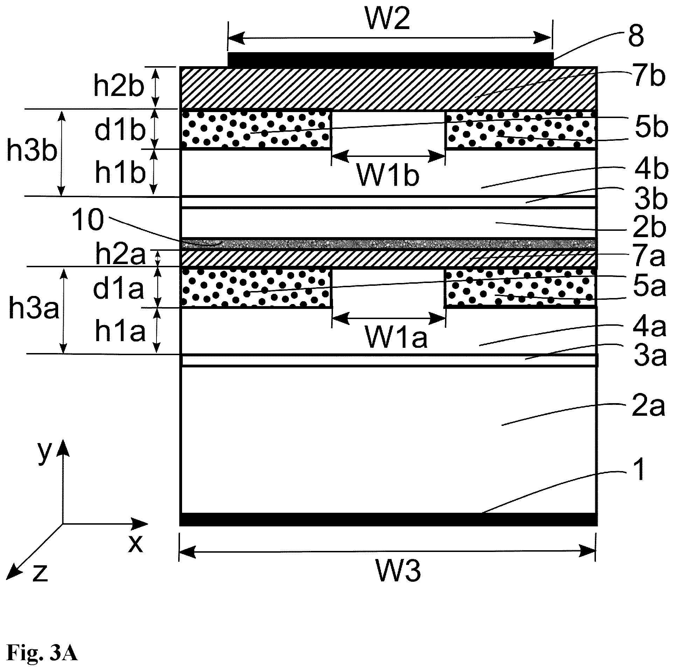

Fig. 3A zeigt eine weitere Ausführungsvariante einer erfindungsgemäßen Laserdiode in schematischer geschnittener Darstellung. In dieser Ausführungsvariante ist die Laserdiode entlang der zweiten Achse Y mit zwei gestapelten Emittern a, b ausgebildet, wobei je Emitter eine Strombarriere 5a, 5b ausgebildet ist. Vorzugsweise sind die beiden Emitter durch eine Tunneldiode 10 von einander getrennt. Bei dieser Ausführungsvariante kann mit dem gleichen Strom durch die Kontakte 1, 8 doppelt so viel Lichtleistung erzeugt werden bei gleichbleibender Nutzung von Strombarrieren 5a, 5b, um der Aufweitung des Stroms entgegenzuwirken.

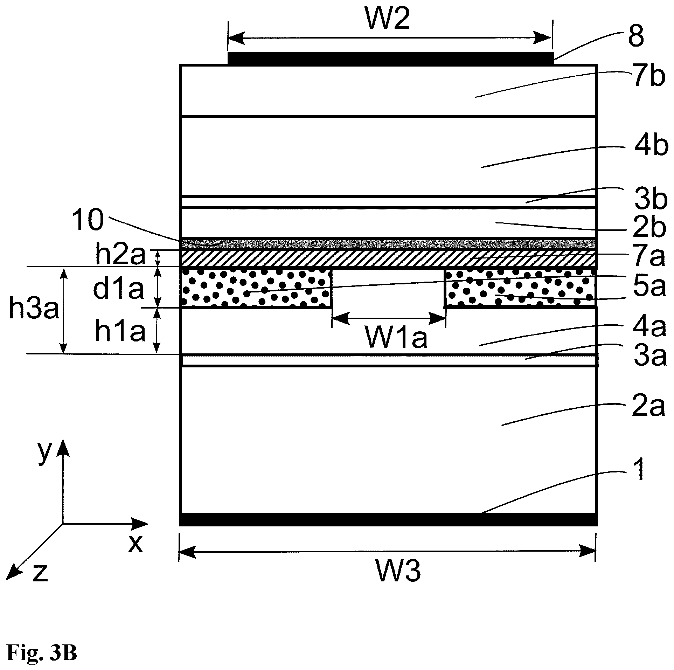

Fig. 3B zeigt eine weitere Ausführungsvariante einer erfindungsgemäßen Laserdiode in schematischer geschnittener Darstellung. Bei dieser Ausführungsvariante einer Laserdioden mit zwei gestapelten Emittern a, b entlang der zweiten Achse Y wird der Aufweitung des Stroms nur durch eine Strombarriere 5a für den untersten Emitter verhindert. Vorteil dieser Ausführungsvariante gegenüber der von Fig. 3A ist die einfachere Herstellung, da nur eine Strombarriere ausgebildet werden muss.

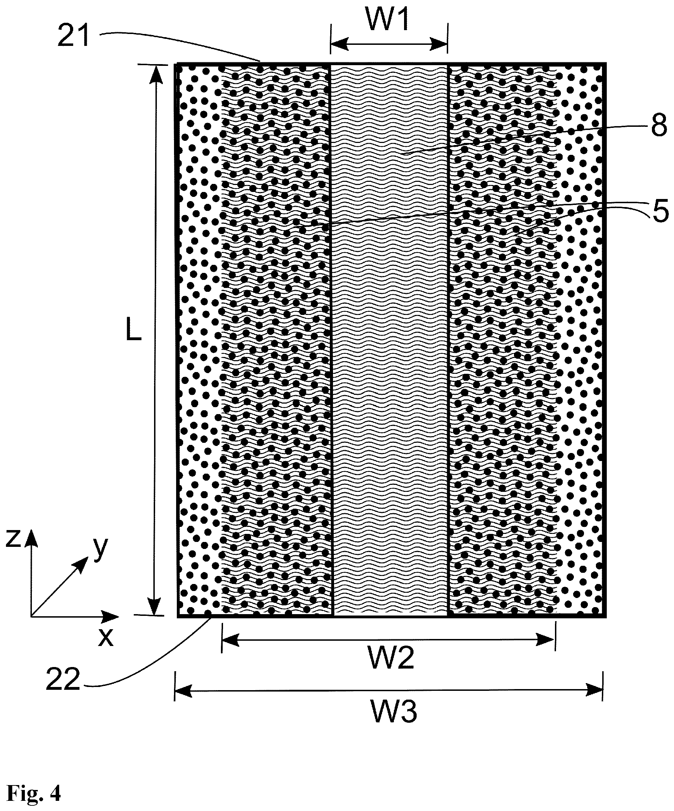

Fig. 4 zeigt die erfindungsgemäße Laserdiode aus Fig. 1 in schematischer Darstellung in einer Draufsicht. Der metallische p-Kontakt 8 wird transparent als Wellenmuster dargestellt, um die darunter liegende Öffnung der Strombarriere 5 nicht zu verdecken. In dieser Ausführungsvariante hat die Strombarriere 5 eine Öffnung. Die Breite W1 der Öffnung erstreckt sich unverändert in Richtung der ersten Achse Z.

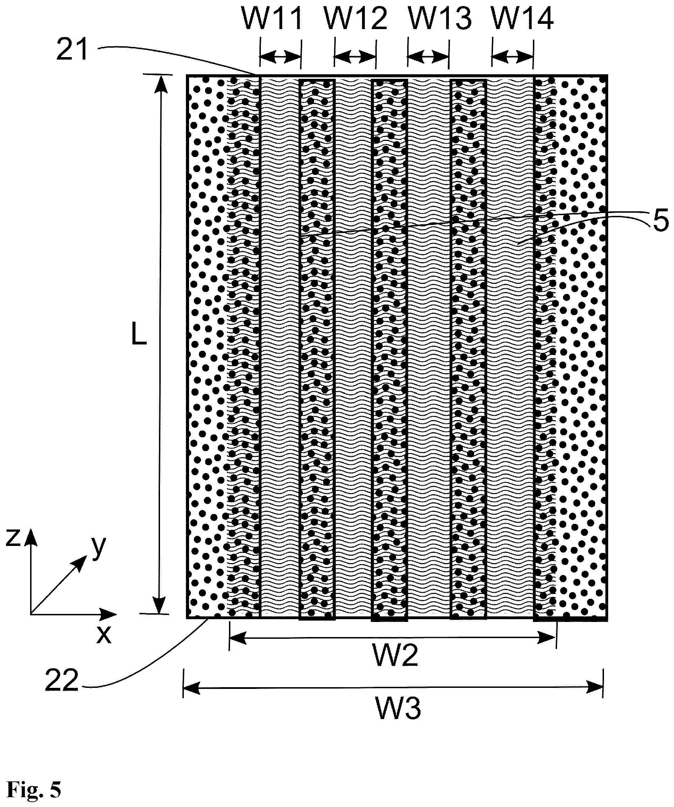

Fig. 5 zeigt die erfindungsgemäße Laserdiode aus Fig. 2 in schematischer Darstellung in einer Draufsicht. In dieser Ausführungsvariante hat die Strombarriere 5 vier Öffnungen mit Breiten W11, W12, W13 und W14. Die Breiten W11, W12, W13, W14 der Öffnungen bleiben konstant in Richtung der ersten Achse Z. In einer bevorzugten Ausführungsvariante sind die die Breiten W11, W12, W13 und W14 der Öffnungen der Stromblende gleich groß, wodurch eine besonders homogene Leistungsverteilung entlang der zweiten Achse Y erreicht wird.

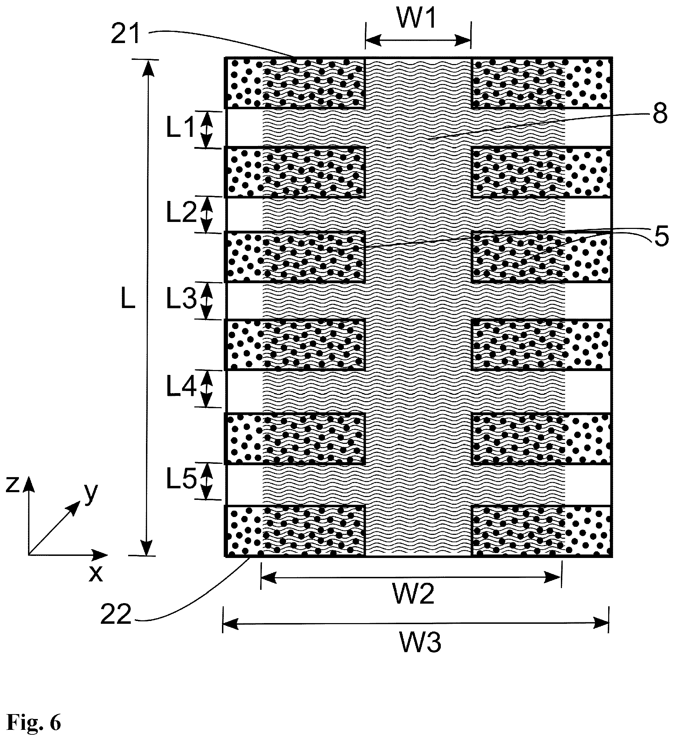

Fig. 6 zeigt eine weitere Ausführungsvariante der erfindungsgemäßen Laserdiode aus Fig. 1 in schematischer Darstellung in einer Draufsicht. In dieser Ausführungsvariante sind sechs Strombarrieren 5 entlang der ersten Achse Z voneinander beabstandet mit Abständen L1, L2, L3, L4 und L5. Jeder der Strombarrieren hat eine Öffnung mit der gleichen Breite W1 und in der gleichen Position relativ zur dritten Achse X. In einer bevorzugten Ausführung sind die Abstände der Strombarrieren 5 äquidistant, d.h. die Abstände L1, L2, L3, L4 und L5 sind gleich groß. Dadurch wird eine periodische Modulation der Stromdichte und somit der injizierten Ladungsträger in der aktiven Schicht entlang der ersten Achse Z erreicht, wodurch das optische Laserstrahlfeld ebenfalls periodisch moduliert wird. Dadurch kann die Filamentierung in Breitstreifenlasern unterdrückt und damit die Strahlqualität verbessert werden.

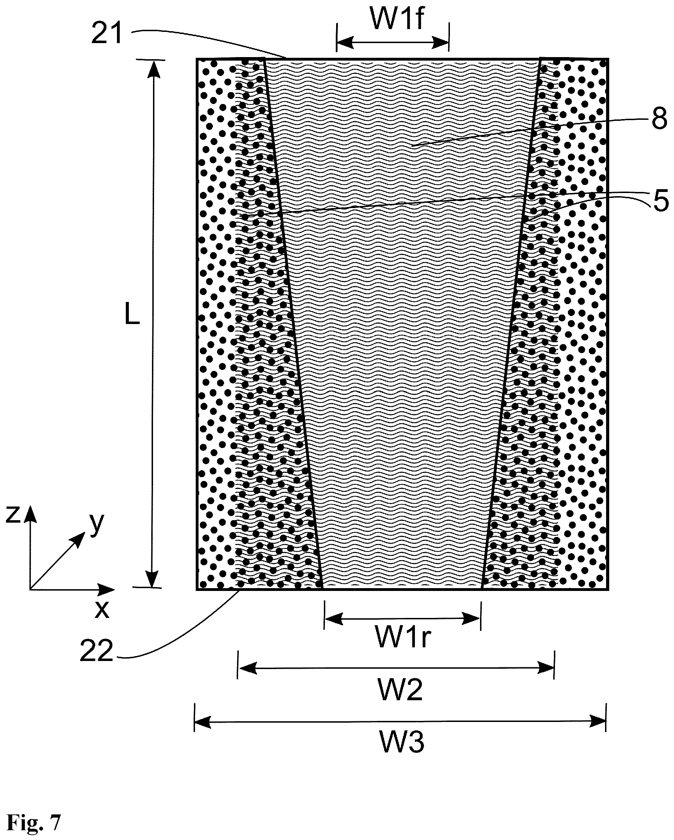

Fig. 7 zeigt eine weitere Ausführungsvariante der erfindungsgemäßen Laserdiode aus Fig. 1 in schematischer Darstellung in einer Draufsicht. Bei dieser Ausführungsvariante gibt es eine Strombarriere 5 mit einer Öffnung. Die Öffnung variiert in ihrer Breite (von W1r zu W1f) in Richtung der dritten Achse X entlang der ersten Achse Z. Hiermit kann die optische Leistungsdichte entlang der ersten Achse Z variiert werden.

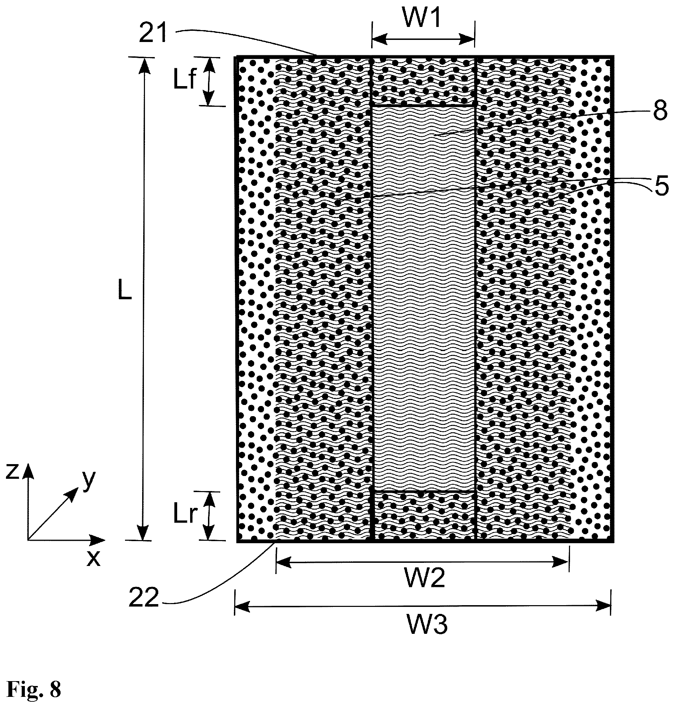

Fig. 8 zeigt eine weitere Ausführungsvariante der erfindungsgemäßen Laserdiode aus Fig. 1 in schematischer Darstellung in einer Draufsicht. Bei dieser Ausführungsvariante erstrecken sich die Strombarrieren mit einer Ausdehnung entlang der ersten Achse Z von Lf und Lr auch entlang eines Bereichs der Facetten 21, 22. Dadurch kann die Lebensdauer des Lasers erhöht werden.

### Bezugszeichenliste

- 1: Metallischer n-Kontakt
- 2: Erste n-leitend ausgebildete Funktionsschichten inklusive n-leitendes Trägersubstrat
- 3: Aktive Schicht
- 4: Erste p-leitende Funktionsschichten
- 5: Strombarriere
- 6: Grenzfläche zwischen den ersten p-leitende Funktionsschichten und den zweiten p-leitenden Funktionsschichten
- 7: Zweite p-leitende Funktionsschichten
- 8: Metallischer p-Kontakt
- X: Dritte Achse
- Y: Zweite Achse
- Z: Erste Achse
- h1: Abstand der Strombarriere von der aktiven Schicht (Dicke eines nicht implantierten Teils der ersten p-leitenden Schichten)
- d1: Dicke der Strombarriere
- h2: Dicke der zweiten p-leitenden Schichten
- h3: Dicke der ersten p-leitenden Schichten
- W1: Erste Breite der Öffnung der Strombarriere
- W2: Zweite Breite des metallischen p-Kontaktes
- W3: Dritte Breite des metallischen n-Kontaktes
- W11-W14: Breite von Öffnungen in einer Strombarriere
- W1a: Breite der Öffnung einer ersten Strombarriere
- W1b: Breite der Öffnung einer zweiten Strombarriere
- W1r: Breite der Öffnung einer Strombarriere an einer ersten Facette
- W1f: Breite der Öffnung einer Strombarriere an einer zweiten Facette
- L: Abstand der Facetten (Länge des Resonators)
- L1-L5: Abstände der Strombarrieren
- 10: Tunnel-Diode
- 21: Erste Facette
- 22: Zweite Facette
- 2a-7a: Schichten des ersten Lasers
- 2b-7b: Schichten des zweiten Lasers

## Patentansprüche

1. Diodenlaser, aufweisend:
a) erste n-leitend ausgebildete Funktionsschichten (2);
b) einen metallischen n-Kontakt (1);
c) eine aktive Schicht (3), die zur Erzeugung elektromagnetischer Strahlung geeignet ist und die auf den ersten Funktionsschichten (2) angeordnet ist;
d) zweite p-leitend ausgebildete Funktionsschichten (4, 7), die auf der aktiven Schicht (3) angeordnet sind, wobei die zweiten Funktionsschichten (4, 7) erste p-leitende Schichten (4) und zweite p-leitende Schichten (7) umfassen, wobei die ersten p-leitenden Schichten (4) eine p-Wellenleiterschicht und eine p-Mantelschicht umfassen und die zweiten p-leitenden Schichten (7) eine p-Kontaktschicht umfassen;
e) einen metallischen p-Kontakt (8);
f) eine Strombarriere (5), die zwischen den ersten p-leitenden Schichten (4) und den zweiten p-leitenden Schichten (7) angeordnet ist; und
g) mindestens eine Facette zur Auskopplung elektromagnetischer Strahlung entlang einer ersten Achse (Z), wobei die ersten Funktionsschichten (2), die aktive Schicht (10) und die zweiten Funktionsschicht (4, 7) entlang einer zweiten Achse (Y) gestapelt sind;
h) wobei sich die Strombarriere (5) entlang einer dritten Achse (X) erstreckt;
i) wobei die Strombarriere (5) mindestens eine Öffnung aufweist;
j) wobei eine erste Breite (W1) der Öffnung der Strombarriere (5) entlang der dritten Achse (X) kleiner als eine zweite Breite (W2) des metallischen p-Kontaktes (8) entlang der dritten Achse (X) ist und eine Projektion der ersten Breite (W1) auf den metallischen p-Kontakt (8) innerhalb der zweiten Breite (W2) liegt;
k) wobei eine Dicke der Strombarriere (5) größer als 0.1 µm ist;
l) wobei die Strombarriere (5) durch das Einbringen von Fremdatomen in die ersten p-leitenden Schichten (4) mittels Implantation oder Diffusion ausgebildet ist; und
m) wobei ein spezifischer elektrischer Widerstand der Strombarriere (5) mehr als das Zweifache eines spezifischen elektrischen Widerstands der Schichtstruktur ist;
**dadurch gekennzeichnet, dass**
n) die Dicke (h3) der ersten p-leitenden Schichten (4) kleiner als 2 µm und die Dicke (h2) der zweiten p-leitenden Schichten größer als 0.5 µm ist.

2. Diodenlaser nach Anspruch 1, wobei die Strombarriere nur in Teilbereichen der ersten p-leitenden Schichten eingebracht ist.

3. Diodenlaser nach einem der vorhergehenden Ansprüche, wobei die ersten p-leitenden Schichten (4) und die zweiten p-leitenden Schichten (7) aus unterschiedlichen Materialien bestehen.

4. Diodenlaser nach einem der vorhergehenden Ansprüche, wobei eine Dicke (h3) der ersten p-leitenden Schichten (4) kleiner als eine Dicke (h2) der zweiten p-leitenden Schicht (7) ist.

5. Diodenlaser nach einem der vorhergehenden Ansprüche, wobei die Strombarriere (5) eine Vielzahl von Öffnungen aufweist, wobei eine Projektion der Öffnungen entlang der zweiten Achse (Y) mit dem metallischen p-Kontakt (8) vollständig überlappt.

6. Diodenlaser nach einem der vorhergehenden Ansprüche, wobei mindestens zwei aktive Schichten (3a, 3b) entlang der zweiten Achse (Y) von einander beabstandet ausgebildet sind, und wobei mindestens zwei Strombarrieren (5a, 5b) vorgesehen sind, die entlang der zweiten Achse (Y) von einander beabstandet ausgebildet sind.

7. Diodenlaser nach einem der Ansprüche 1 bis 5, wobei mindestens zwei aktive Schichten (3a, 3b) entlang der zweiten Achse (Y) von einander beabstandet ausgebildet sind, und wobei nur eine Strombarriere (5a) vorgesehen ist.

8. Diodenlaser nach einem der vorhergehenden Ansprüche, wobei mindestens zwei Strombarrieren (5) vorgesehen sind, die entlang der ersten Achse (Z) von einander beabstandet ausgebildet sind.

9. Diodenlaser nach einem der vorhergehenden Ansprüche, wobei die Breite (W1r, W1f) der Öffnung der Strombarriere (5) entlang der ersten Achse (Z) variiert.

10. Verfahren zur Herstellung eines Diodenlasers mit folgenden Verfahrensschritten:
a) Ausbilden von ersten n-leitend ausgebildeten Funktionsschichten (2);
b) Ausbilden einer aktiven Schicht (3), die zur Erzeugung elektromagnetischer Strahlung geeignet ist und die auf den ersten Funktionsschichten (2) angeordnet ist;
c) Ausbilden von ersten p-leitende Schichten (4) auf der aktiven Schicht (3);
d) Einbringen von Fremdatomen in die ersten p-leitenden Schichten (4) zur Ausbildung einer Strombarriere (5), wobei die ersten p-leitenden Schichten (4) eine p-Wellenleiterschicht und eine p-Mantelschicht umfassen, wobei die Dicke (h3) der ersten p-leitenden Schichten (4) kleiner als 2 µm ist;
e) Nachfolgendes Ausbilden von zweiten p-leitenden Schichten (7) auf den ersten p-leitenden Schichten (4), wobei die zweiten p-leitenden Schichten (7) eine p-Kontaktschicht umfassen, wobei die Dicke (h2) der zweiten p-leitenden Schichten (7) größer als 0.5 µm ist;
f) Ausbilden eines metallischen n-Kontaktes (1) unter den ersten n-leitend ausgebildeten Funktionsschichten (2) und Ausbilden eines metallischen p-Kontaktes (8) auf den zweiten p-leitenden Schichten (7);
g) wobei das Einbringen der Fremdatome lediglich in Teilbereichen der ersten p-leitenden Schichten (4) erfolgt;
h) wobei eine Breite (W1) eines Teilbereichs der ersten p-leitenden Schichten (4), in den keine Fremdatome eingebracht werden, kleiner als eine Breite (W2) des metallischen p-Kontaktes (8) ist und eine Projektion der ersten Breite (W1) auf den metallischen p-Kontakt (8) innerhalb der zweiten Breite (W2) liegt;
i) wobei eine Dicke der Strombarriere (5) größer als 0.1 µm ausgebildet wird;
j) wobei die Strombarriere (5) durch das Einbringen von Fremdatomen in die ersten p-leitenden Schichten (4) mittels Implantation oder Diffusion ausgebildet wird; und
k) wobei die Strombarriere (5) derart ausgebildet wird, dass ein spezifischer elektrischer Widerstand der Strombarriere (5) mehr als das Zweifache eines spezifischen elektrischen Widerstands der Schichtstruktur ist.

11. Verfahren nach Anspruch 10, wobei das Einbringen der Fremdatome mittels einer strukturierten Maske erfolgt.

12. Verfahren nach Anspruch 11, wobei die Maske vor dem Einbringen der Fremdatome auf den ersten p-leitenden Schichten (4) ausgebildet wird und nach dem Einbringen der Fremdatome in die ersten p-leitenden Schichten (4) wieder entfernt wird.

13. Verfahren nach einem der Ansprüche 10 bis 12, wobei als Fremdatome Silizium, Sauerstoff, Eisen oder Selen in die ersten p-leitenden Schichten (4) eingebracht werden.

14. Verfahren nach einem der Ansprüche 10 bis 13, wobei die ersten n-leitend ausgebildeten Funktionsschichten (2), die aktive Schicht (3), die ersten p-leitenden Schichten (4) und die zweiten p-leitenden Schichten mittels Epitaxieverfahren ausgebildet werden.

15. Verfahren nach einem der Ansprüche 10 bis 14, wobei eine Dicke (h3) der ersten p-leitenden Schichten (4) kleiner als eine Dicke (h2) der zweiten p-leitenden Schichten (7) ausgebildet wird.

## Claims

1. A diode laser, having:
a) first n-type functional layers (2);
b) a metallic n-contact (1);
c) an active layer (3) operable to generate electromagnetic radiation and disposed on the first functional layers (2);
d) second p-type functional layers (4, 7) disposed on the active layer (3), wherein the second functional layers (4, 7) comprise first p-type layers (4) and second p-type layers (7), wherein the first p-type layers (4) comprise a p-waveguide layer and a p-cladding layer and the second p-type layers (7) comprise a p-contact layer;
e) a metallic p-contact (8);
f) a current barrier (5) disposed between the first p-type layers (4) and the second p-type layers (7); and
g) at least one facet for coupling out electromagnetic radiation along a first axis (Z), wherein the first functional layers (2), the active layer (10) and the second functional layer (4, 7) are stacked along a second axis (Y);
h) wherein the current barrier (5) extends along a third axis (X);
i) wherein the current barrier (5) has at least one opening;
j) wherein a first width (W1) of the opening of the current barrier (5) along the third axis (X) is less than a second width (W2) of the metallic p-contact (8) along the third axis (X), and a projection of the first width (W1) onto the metallic p-contact (8) lies within the second width (W2);
k) wherein a thickness of the current barrier (5) is greater than 0.1 µm;
l) wherein the current barrier (5) is formed by incorporating impurity atoms into the first p-type layers (4) by means of implantation or diffusion; and
m) wherein a resistivity of the current barrier (5) is more than twice a resistivity of the layer structure;
**characterised in that**
n) the thickness (h3) of the first p-type layers (4) is less than 2 µm and the thickness (h2) of the second p-type layers is greater than 0.5 µm.

2. The diode laser according to claim 1, wherein the current barrier is incorporated only in partial regions of the first p-type layers.

3. The diode laser according to any preceding claim, wherein the first p-type layers (4) and the second p-type layers (7) are made of different materials.

4. The diode laser according to any preceding claim, wherein a thickness (h3) of the first p-type layers (4) is less than a thickness (h2) of the second p-type layer (7).

5. The diode laser according to any preceding claim, wherein the current barrier (5) has a plurality of openings, wherein a projection of the openings along the second axis (Y) completely overlaps the metallic p-contact (8).

6. The diode laser according to any preceding claim, wherein at least two active layers (3a, 3b) are formed spaced apart from one another along the second axis (Y), and wherein at least two current barriers (5a, 5b) are provided, which are formed spaced apart from one another along the second axis (Y).

7. The diode laser according to any one of claims 1 to 5, wherein at least two active layers (3a, 3b) are formed spaced apart from one another along the second axis (Y), and wherein only one current barrier (5a) is provided.

8. The diode laser according to any preceding claim, wherein at least two current barriers (5) are provided, which are formed spaced apart from one another along the first axis (Z).

9. The diode laser according to any preceding claim, wherein the width (W1r, W1f) of the opening of the current barrier (5) varies along the first axis (Z).

10. A method of manufacturing a diode laser, comprising the following method steps:
a) forming first n-type functional layers (2);
b) forming an active layer (3) operable to generate electromagnetic radiation and disposed on the first functional layers (2);
c) forming first p-type layers (4) on the active layer (3);
d) incorporating impurity atoms into the first p-type layers (4) to form a current barrier (5), wherein the first p-type layers (4) comprise a p-waveguide layer and a p-cladding layer, wherein the thickness (h3) of the first p-type layers (4) is less than 2 µm;
e) subsequently forming second p-type layers (7) on the first p-type layers (4), wherein the second p-type layers (7) comprise a p-contact layer, wherein the thickness (h2) of the second p-type layers (7) is greater than 0.5 µm;
f) forming a metallic n-contact (1) under the first n-type functional layers (2) and forming a metallic p-contact (8) on the second p-type layers (7);
g) wherein incorporating the impurity atoms is only carried out in partial regions of the first p-type layers (4);
h) wherein a width (W1) of a partial region of the first p-type layers (4) into which no impurity atoms are incorporated is less than a width (W2) of the metallic p-contact (8), and a projection of the first width (W1) onto the metallic p-contact (8) lies within the second width (W2);
i) wherein a thickness of the current barrier (5) is formed to be greater than 0.1 µm;
l) wherein the current barrier (5) is formed by incorporating impurity atoms into the first p-type layers (4) by means of implantation or diffusion; and
k) wherein the current barrier (5) is formed such that a resistivity of the current barrier (5) is more than twice a resistivity of the layer structure.

11. The method according to claim 10, wherein incorporating the impurity atoms is carried out by means of a patterned mask.

12. The method according to claim 11, wherein the mask is formed on the first p-type layers (4) before incorporating the impurity atoms and is removed again after incorporating the impurity atoms into the first p-type layers (4).

13. The method according to any one of claims 10 to 12, wherein silicon, oxygen, iron or selenium are incorporated into the first p-type layers (4) as the impurity atoms.

14. The method according to any one of claims 10 to 13, wherein the first n-type functional layers (2), the active layer (3), the first p-type layers (4) and the second p-type layers are formed by means of epitaxial methods.

15. The method according to any one of claims 10 to 14, wherein a thickness (h3) of the first p-type layers (4) is formed to be less than a thickness (h2) of the second p-type layers (7).

## Revendications

1. Laser à diode, présentant :
a) des premières couches fonctionnelles conductrices de type n (2) ;
b) un contact métallique de type n (1) ;
c) une couche active (3) apte à produire un rayonnement électromagnétique et disposée sur les premières couches fonctionnelles (2) ;
d) des deuxièmes couches fonctionnelles conductrices de type p (4, 7), qui sont disposées sur la couche active (3), les deuxièmes couches fonctionnelles (4, 7) comprenant des premières couches conductrices de type p (4) et des deuxièmes couches conductrices de type p (7), les premières couches conductrices de type p (4) comprenant une couche de guide d'ondes de type p et une couche de confinement de type p et les deuxièmes couches conductrices de type p (7) comprenant une couche de contact de type p ;
e) un contact métallique de type p (8) ;
f) une barrière de courant (5) disposée entre les premières couches conductrices de type p (4) et les deuxièmes couches conductrices de type p (7) ; et
g) au moins une facette pour extraire un rayonnement électromagnétique le long d'un premier axe (Z), les premières couches fonctionnelles (2), la couche active (10) et la deuxième couche fonctionnelle (4, 7) étant empilées le long d'un deuxième axe (Y) ;
h) dans lequel la barrière de courant (5) s'étend le long d'un troisième axe (X) ;
i) dans lequel la barrière de courant (5) présente au moins une ouverture ;
j) dans lequel une première largeur (W1) de l'ouverture de la barrière de courant (5) le long du troisième axe (X) est inférieure à une deuxième largeur (W2) du contact métallique de type p (8) le long du troisième axe (X) et une projection de la première largeur (W1) sur le contact métallique de type p (8) se trouve à l'intérieur de la deuxième largeur (W2) ;
k) dans lequel une épaisseur de la barrière de courant (5) est supérieure à 0,1 µm ;
l) dans lequel la barrière de courant (5) est formée par l'introduction des atomes étrangers dans les premières couches conductrices de type p (4) par implantation ou diffusion ; et
m) dans lequel une résistance électrique spécifique de la barrière de courant (5) est plus de deux fois supérieure à une résistance électrique spécifique de la structure en couches ;
**caractérisé en ce que**
n) l'épaisseur (h3) des premières couches conductrices de type p (4) est inférieure à 2 µm et l'épaisseur (h2) des deuxièmes couches conductrices de type p est supérieure à 0,5 µm.

2. Laser à diode selon la revendication 1, dans lequel la barrière de courant n'est appliquée qu'à des parties des premières couches conductrices de type p.

3. Laser à diode selon l'une quelconque des revendications précédentes, dans lequel les premières couches conductrices de type p (4) et les deuxièmes couches conductrices de type p (7) sont constituées de matériaux différents.

4. Laser à diode selon l'une quelconque des revendications précédentes, dans lequel une épaisseur (h3) des premières couches conductrices de type p (4) est inférieure à une épaisseur (h2) de la deuxième couche conductrice de type p (7).

5. Laser à diode selon l'une quelconque des revendications précédentes, dans lequel la barrière de courant (5) présente une pluralité d'ouvertures, une projection des ouvertures le long du deuxième axe (Y) chevauchant complètement le contact métallique de type p (8).

6. Laser à diode selon l'une quelconque des revendications précédentes, dans lequel au moins deux couches actives (3a, 3b) sont formées à distance l'une de l'autre le long du deuxième axe (Y), et dans lequel au moins deux barrières de courant (5a, 5b), qui sont formées à distance l'une de l'autre le long du deuxième axe (Y), sont prévues.

7. Laser à diode selon l'une des revendications 1 à 5, dans lequel au moins deux couches actives (3a, 3b) sont formées à distance l'une de l'autre le long du deuxième axe (Y), et dans lequel une seule barrière de courant (5a) est prévue.

8. Laser à diode selon l'une quelconque des revendications précédentes, dans lequel au moins deux barrières de courant (5), qui sont formées à distance l'une de l'autre le long du premier axe (Z), sont prévues.

9. Laser à diode selon l'une quelconque des revendications précédentes, dans lequel la largeur (W1r, W1f) de l'ouverture de la barrière de courant (5) varie le long du premier axe (Z).

10. Procédé de fabrication d'un laser à diode, le procédé comprenant les étapes suivantes :
a) la formation de premières couches fonctionnelles conductrices de type n (2) ;
b) la formation d'une couche active (3) apte à produire un rayonnement électromagnétique et disposée sur les premières couches fonctionnelles (2) ;
c) la formation de premières couches conductrices de type p (4) sur la couche active (3) ;
d) l'introduction des atomes étrangers dans les premières couches conductrices de type p (4) pour la formation d'une barrière de courant (5), les premières couches conductrices de type p (4) comprenant une couche de guide d'ondes de type p et une couche de confinement de type p, l'épaisseur (h3) des premières couches conductrices de type p (4) étant inférieure à 2 µm ;
e) la formation subséquente de deuxièmes couches conductrices de type p (7) sur les premières couches conductrices de type p (4), les deuxièmes couches conductrices de type p (7) comprenant une couche de contact de type p, l'épaisseur (h2) des deuxièmes couches conductrices de type p (7) étant supérieure à 0,5 µm ;
f) la formation d'un contact métallique de type n (1) sous les premières couches fonctionnelles conductrices de type n (2) et la formation d'un contact métallique de type p (8) sur les deuxièmes couches conductrices de type p (7) ;
g) dans lequel l'introduction des atomes étrangers ne s'effectue que dans des parties des premières couches conductrices de type p (4) ;
h) dans lequel une largeur (W1) d'une partie des premières couches conductrices de type p (4), dans lequel aucun atome étranger n'est introduit, est inférieure à une largeur (W2) du contact métallique de type p (8) et une projection de la première largeur (W1) sur le contact métallique de type p (8) se trouve à l'intérieur de la deuxième largeur (W2) ;
i) dans lequel une épaisseur de la barrière de courant (5) supérieure à 0,1 µm est formée ;
j) dans lequel la barrière de courant (5) est formée par l'introduction des atomes étrangers dans les premières couches conductrices de type p (4) par implantation ou diffusion ; et
k) dans lequel la barrière de courant (5) est formée de telle sorte qu'une résistance électrique spécifique de la barrière de courant (5) est plus de deux fois supérieure à une résistance électrique spécifique de la structure en couches.

11. Procédé selon la revendication 10, dans lequel l'introduction des atomes étrangers s'effectue au moyen d'un masque structuré.

12. Procédé selon la revendication 11, dans lequel le masque est formé sur les premières couches conductrices de type p (4) avant l'introduction des atomes étrangers et est éliminé après l'introduction des atomes étrangers dans les premières couches conductrices de type p (4).

13. Procédé selon l'une des revendications 10 à 12, dans lequel on introduit comme atomes étrangers du silicium, de l'oxygène, du fer ou du sélénium dans les premières couches conductrices de type p (4).

14. Procédé selon l'une des revendications 10 à 13, dans lequel les premières couches fonctionnelles conductrices de type n (2), la couche active (3), les premières couches conductrices de type p (4) et les deuxièmes couches conductrices de type p sont formées par des procédés d'épitaxie.

15. Procédé selon l'une des revendications 10 à 14, dans lequel une épaisseur (h3) des premières couches conductrices de type p (4) est formée de manière à être inférieure à une épaisseur (h2) des deuxièmes couches conductrices de type p (7).
